(19) Europäisches Patentamt
European Patent Office
Office européen des brevets

(11) Veröffentlichungsnummer: **0 387 578 B1**

(12) **EUROPÄISCHE PATENTSCHRIFT**

(45) Veröffentlichungstag der Patentschrift: **03.08.94**

(51) Int. Cl.[5]: **G03F 7/027**, G03F 7/031, G03F 7/20

(21) Anmeldenummer: **90103666.5**

(22) Anmeldetag: **26.02.90**

(54) **Verfahren zur Herstellung einer Reliefdruckplatte mit klebfreier druckender Oberfläche.**

(30) Priorität: **13.03.89 DE 3908059**

(43) Veröffentlichungstag der Anmeldung:
**19.09.90 Patentblatt 90/38**

(45) Bekanntmachung des Hinweises auf die Patenterteilung:
**03.08.94 Patentblatt 94/31**

(84) Benannte Vertragsstaaten:
**BE CH DE FR GB IT LI NL**

(56) Entgegenhaltungen:
**EP-A- 0 017 927**
**FR-A- 2 392 411**
**US-A- 3 871 885**
**US-A- 4 281 152**

(73) Patentinhaber: **BASF Aktiengesellschaft**
**Carl-Bosch-Strasse 38**
**D-67063 Ludwigshafen(DE)**

(72) Erfinder: **Telser, Thomas, Dr.**
**Langer Wiesenweg 13**
**D-6940 Weinheim(DE)**
Erfinder: **Boettcher, Andreas, Dr.**
**Konrad-Adenauer-Ring 38**
**D-6907 Nussloch(DE)**
Erfinder: **Seitz, Friedrich, Dr.**
**Von-Wieser-Strasse 1**
**D-6701 Friedelsheim(DE)**

**EP 0 387 578 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Vorliegende Erfindung betrifft ein neues Verfahren zur Herstellung einer Reliefdruckplatte mit klebfreier druckender Oberfläche aus einem lichtempfindlichen Aufzeichnungselement, welches einen dimensionsstabilen Träger und eine photopolymerisierbare reliefbildende Aufzeichnungsschicht enthält, die neben mindestens einem polymeren Bindemittel, mindestens einem photopolymerisierbaren olefinisch ungesättigten Monomeren und mindestens einem Photopolymerisationsinitiator noch mindestens eine weitere lichtempfindliche Verbindung enthält. Das neue Herstellverfahren umfaßt die Verfahrensschritte des bildmäßigen Belichtens der photopolymerisierbaren reliefbildenden Aufzeichnungsschicht mit aktinischem Licht, das Auswaschen (Entwickeln) der unbelichteten und daher nicht photopolymerisierten Bereiche der bildmäßig belichteten reliefbildenden Aufzeichnungsschicht mit einem Entwicklerlösungsmittel und das Nachbelichten (Nachbehandeln) der in dieser Weise erhaltenen photopolymerisierten Reliefschicht mit Licht einer Wellenlänge $\lambda \leqq 300$ nm.

Außerdem betrifft die Erfindung ein neues lichtempfindliches Aufzeichnungselement, welches besonders gut für das neue Herstellverfahren geeignet ist.

Des weiteren betrifft die vorliegende Erfindung die Verwendung von Benzophenon und Benzophenonderivaten bei dem neuen Herstellverfahren.

Lichtempfindliche Aufzeichnungselemente für die Herstellung von Reliefdruckplatten, welche einen dimensionsstabilen Träger und eine photopolymerisierbare reliefbildende Aufzeichnungsschicht mit mindestens einem polymeren Bindemittel, mindestens einem photopolymerisierbaren olefinisch ungesättigten Monomeren, das mit dem polymeren Bindemittel verträglich ist, mindestens einem Photopolymerisationsinitiator und mit mindestens einer weiteren lichtempfindlichen Verbindung enthalten, sind beispielsweise aus der DE-A-27 22 421, der DE-A-27 20 599, der DE-A-27 20 560 oder der DE-A-32 48 247 bekannt.

Außerdem gehen Verfahren zur Herstellung von Reliefdruckplatten mit klebfreier druckender Oberfläche, welche die eingangs genannten Verfahrensschritte umfassen, aus der DE-A-28 21 500 und der EP-B-0 017 927 hervor.

Bei dem in der DE-A-28 21 500 beschriebenen Herstellverfahren wird die durch bildmäßiges Belichten und Auswaschen (Entwickeln) der unbelichteten und daher nicht photopolymerisierten Bereiche der bildmäßig belichteten reliefbildenden Aufzeichnungsschicht erzeugte Reliefschicht vor dem Nachbelichten (Nachbehandeln) mit Licht einer Wellenlänge $\lambda \leqq 300$ nm in ihrer Oberfläche mit einer wasserstoffabstrahierenden Verbindung wie 9,10-Anthrachinon imprägniert.

Bei dem Herstellverfahren, welches in der EP-B-0 017 927 beschrieben ist, wird ein lichtempfindliches Aufzeichnungselement verwendet, das als wesentlichen Bestandteil ein lösungsmittelösliches Polymeres mit Polymersegmenten aus einem konjugierten Dienmonomeren in der Hauptkette sowie mindestens ein photopolymerisierbares olefinisch ungesättigtes Monomeres und einen Photopolymerisationsinitiator enthält. Wie aus Spalte 7, Zeilen 45 bis 60, dieser Patentschrift hervorgeht, können Benzophenon, Michlers Keton oder neunzehn sonstige Verbindungen als Photopolymerisationsinitiatoren verwendet werden. Außerdem wird hierin angegeben, daß die genannten einundzwanzig Photopolymerisationsinitiatoren entweder für sich alleine oder in Kombination angewendet werden können. Welche Photopolymerisationsinitiatoren hierbei miteinander kombiniert werden sollen, wird indes nicht gesagt.

Diese beiden bekannten Herstellverfahren weisen indes Nachteile auf. Entweder erfordern sie einen zusätzlichen Behandlungsschritt, z.B. das Imprägnieren der Oberfläche der photopolymerisierten Reliefschicht mit 9,10-Anthrachinon, oder sie sind auf lichtempfindliche Aufzeichnungselemente mit photopolymerisierbaren reliefbildenden Aufzeichnungsschichten spezieller Zusammensetzung beschränkt und führen bei anderen lichtempfindlichen Aufzeichnungselementen nicht zu dem gewünschten Verfahrenserfolg, nämlich der Erzeugung einer klebfreien druckenden Oberfläche. Nachteilig ist auch die lange Bestrahlungszeit, welche für die Nachbelichtung der photopolymerisierten Reliefschichten mit Licht einer Wellenlänge $\lambda \leqq 300$ nm notwendig ist. Hierbei kommt es nämlich gleichzeitig mit der Entklebung zu einer Versprödung der Oberfläche der photopolymerisierten Reliefschicht, was die Bildung von Rissen zur Folge hat. Diese Risse in der druckenden Oberfläche der photopolymerisierten Reliefschicht machen sich zum einen im Druckbild bemerkbar und zum anderen setzen sie die Beständigkeit gegenüber Ozon und Druckfarbenlösungsmitteln herab. Außerdem stellen die für die Entklebung notwendigen langen Belichtungszeiten im reprographischen Betrieb einen Engpaß bei der Reliefdruckplattenherstellung dar. Dieser Engpaß mach sich vor allem bei der Herstellung flexographischer Reliefdruckplatten bemerkbar, deren Nachbelichtungszeit bis zur vollständigen Entklebung ihrer druckenden Oberfläche in der Größenordnung von etwa einer halben Stunde liegt, was indes in der betrieblichen Praxis nur in Ausnahmefällen akzeptabel ist und was sich mit der vorteilhaft kurzen Zeit, welche für die Bromnachbehandlung notwendig ist (vgl. die DE-A-28 23 300 oder die EP-A-0 256 309), nur sehr schlecht vergleicht.

Andererseits weist die Bromnachbehandlung auch Nachteile auf, welche insbesondere auf die hohe Korrosivität der hierzu verwendeten Bromlösungen zurückzuführen sind.

Aufgabe der vorliegenden Erfindung ist es, ein neues Verfahren zur Herstellung einer Reliefdruckplatte, insbesondere einer flexographischen Reliefdruckplatte, deren photopolymerisierte Reliefschicht eine klebfreie druckende Oberfläche hat, zu finden, wobei das neue Verfahren die Verfahrensschritte

(1) bildmäßiges Belichten eines lichtempfindlichen Aufzeichnungselements, welches einen dimensionsstabilen Träger und eine photopolymerisierbare reliefbildende Aufzeichnungsschicht enthält, mit aktinischem Licht,

(2) Auswaschen (Entwickeln) der unbelichteten und daher nicht photopolymerisierten Bereiche der bildmäßig belichteten reliefbildenden Aufzeichnungsschicht mit einem Entwicklerlösungsmittel und

(3) Nachbelichten (Nachbehandeln) der in dieser Weise erhaltenen photopolymerisierten Reliefschicht mit Licht einer Wellenlänge $\lambda \leqq 300$ nm

umfassen und die Nachteile des Standes der Technik nicht mehr aufweisen soll.

Überraschenderweise konnte diese Aufgabe dadurch gelöst werden, daß man mindestens eine weitere lichtempfindliche Verbindung aus der Klasse der substituierten Benzophenone und/oder Benzophenon selbst zur photopolymerisierbaren reliefbildenden Aufzeichnungsschicht des lichtempfindlichen Aufzeichnungselements hinzugibt, welches bei dem neuen Verfahren verwendet wird. Im Hinblick auf den unerwarteten experimentellen Befund, daß Benzophenon für sich allein in den photopolymerisierbaren reliefbildenden Aufzeichnungsschichten bei der Belichtung mit aktinischem Licht nicht als Photopolymerisationsinitiator wirkt, war die Lösung der erfindungsgemäßen Aufgabe um so mehr überraschend.

Demnach handelt es sich bei dem Gegenstand der vorliegenden Erfindung um ein Verfahren zur Herstellung einer Reliefdruckplatte, deren photopolymerisierte Reliefschicht eine klebfreie druckende Oberfläche hat, durch

(1) bildmäßiges Belichten eines lichtempfindlichen Aufzeichnungselements, das

A) einen dimensionsstabilen Träger und

B) eine photopolymerisierbare reliefbildende Aufzeichnungsschicht mit

$b_1$) mindestens einem polymeren Bindemittel,

$b_2$) mindestens einem photopolymerisierbaren olefinisch ungesättigten Monomeren, welches mit dem polymeren Bindemittel ($b_1$) verträglich ist,

$b_3$) mindestens einem Photopolymerisationsinitiator und mit

$b_4$) mindestens einer weiteren lichtempfindlichen Verbindung

enthält, mit aktinischem Licht,

(2) Auswaschen (Entwickeln) der unbelichteten und daher nicht photopolymerisierten Bereiche der bildmäßig belichteten reliefbildenden Aufzeichnungsschicht (B) mit einem Entwicklerlösungsmittel und

(3) Nachbelichten (Nachbehandeln) der in dieser Weise erhaltenen photopolymerisierten Reliefschicht mit Licht einer Wellenlänge $\lambda \leqq 300$ nm,

wobei das Verfahren dadurch gekennzeichnet ist, daß die hierbei verwendete photopolymerisierbare reliefbildende Aufzeichnungsschicht (B) des lichtempfindlichen Aufzeichnungselements als die weitere lichtempfindliche Verbindung ($b_4$) Benzophenon und/oder ein ein- oder mehrfach substituiertes Benzophenon enthält, welches in seinem Substituenten oder in mindestens einem seiner Substituenten mindestens eine photopolymerisierbare olefinisch ungesättigte Gruppe aufweist.

Noch ein weiterer Gegenstand der vorliegenden Erfindung ist das lichtempfindliche Aufzeichnungselement für die Herstellung von Reliefdruckplatten mit klebfreier druckender Oberfläche, welches in seiner photopolymerisierbaren reliefbildenden Aufzeichnungsschicht (B) als weitere lichtempfindliche Verbindung ($b_4$) Benzophenon und/oder die vorstehend genannten substituierten Benzophenone enthält.

Im folgenden wird das neue Verfahren zur Herstellung einer Reliefdruckplatte, deren photopolymerisierte Reliefschicht eine klebfreie druckende Oberfläche hat, der Kürze halber als "erfindungsgemäßes Verfahren" bezeichnet.

Des weiteren werden im folgenden der Kürze halber das neue lichtempfindliche Aufzeichnungselement für die Herstellung von Reliefdruckplatten mit klebfreier druckender Oberfläche als "erfindungsgemäßes Aufzeichnungselement" und die erfindungsgemäß zu verwendenden ein- oder mehrfachsubstituierten Benzophenone, welche in ihrem Substituenten oder in mindestens einem ihrer Substituenten mindestens eine photopolymerisierbare olefinisch ungesättigte Gruppe aufweisen, als "substituierte Benzophenone ($b_4$)" bezeichnet.

Das erfindungsgemäße Verfahren wird mit Hilfe des erfindungsgemäßen Aufzeichnungselements durchgeführt.

Der wesentliche Bestandteil des erfindungsgemäßen Aufzeichnungselements ist seine photopolymerisierbare reliefbildende Aufzeichnungsschicht (B), welche Benzophenon und/oder die substituierten Benzop-

henone ($b_4$) enthält. Hierbei sind Benzophenon und/oder die substituierten Benzophenone ($b_4$) in der photopolymerisierbaren reliefbildenden Aufzeichnungsschicht (B) in einer Menge von, bezogen auf (B), 0,05 bis 5, vorzugsweise 0,1 bis 3 und insbesondere 0,2 bis 1,2 Gew.-% enthalten.

Beispiele geeigneter substituierter Benzophenone ($b_4$) sind Benzophenone der allgemeinen Formel I,

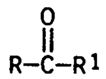

(I)

worin der Rest R für eine unsubstituierte Phenylgruppe oder für den Rest $R^1$ steht. Hierbei bezeichnet der Rest $R^1$ einen substituierten Phenylrest der allgemeinen Formel II,

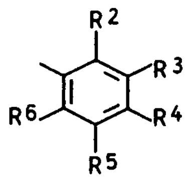

(II)

worin die Reste $R^2$ bis $R^6$ untereinander gleich oder verschieden voneinander sein können und für Wasserstoff- und Halogenatome; für Hydroxy-, Thiolo-, Cyano-, Alkyl-, Aryl-, Alkoxi-, Aryloxi-, Alkanthio-, Arylthio-, Alkoxicarbonyl-, Aryloxicarbonyl-, Alkancarbonyloxi-, Arylcarbonyloxi-, Alkancarbonylamino-, Arylcarbonylamino-, Alkylaminocarbonyl-, Arylaminocarbonyl-, Mono- und Dialkylsulfonamido-, Mono- und Diaralysulfonamido-, Alkylarylsulfonamido-, N,N-Dialkylamino-, N,N-Dicycloalkylamino-, N,N-Diarylamino-, N-Aryl-N-alkylamino-, N-Alkyl-N-cycloalkylamino- oder N-Aryl-N-cycloalkylamino-Gruppen; für Stickstoffatome enthaltende heterocyclische Gruppen, welche über ein Stickstoffatom mit dem substituierten Phenylrest verbunden sind; sowie für einen Substituenten, welcher mindestens eine photopolymerisierbare olefinisch ungesättigte Gruppe aufweist; stehen.

Unabhängig davon, welche Reste $R^2$ bis $R^6$ im einzelnen vorliegen, ist mindestens einer der Reste $R^2$ bis $R^6$ ein Substituent, welcher mindestens eine photopolymerisierbare olefinisch ungesättigte Gruppe aufweist. Indessen können zwei, drei, vier oder fünf dieser Substituenten vorliegen, wobei drei bevorzugt und zwei besonders bevorzugt sind, und ein Substituent ganz besonders bevorzugt ist.

Gut geeignet sind Substituenten, welche eine photopolymerisierbare olefinisch ungesättigte Gruppe aufweisen.

Beispiele gut geeigneter Substituenten sind Substituenten der allgemeinen Formel III,

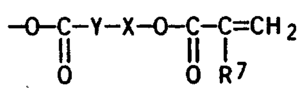

(III)

worin die Variable Y für ein Sauerstoffatom oder für eine Iminogruppe und die Variable X für einen zweiwertigen, perfluorierten oder unfluorierten Alkylenrest oder Oxaalkylenrest

$$-(-CF_2-)_nO-(-CF_2-)_p$$

oder

$$-(-CH_2-)_nO-(-CH_2-)_p,$$

worin die Indices n und p jeweils ganze Zahlen von 1 bis 5 bedeuten; oder für einen unfluorierten oder perfluorierten Polyoxaalkylenrest mit 2 bis 5 Sauerstoffatomen, worin die Sauerstoffatome jeweils über mindestens eine $-CH_2-$ oder eine $-CF_2$-Gruppe miteinander verknüpft sind; steht und worin der Rest $R^7$ ein Wasserstoffatom oder eine Methylgruppe bezeichnet.

Beispiele für besonders gut geeignete Substituenten der allgemeinen Formel III sind die Substituenten III-1 bis III-7:

III-1 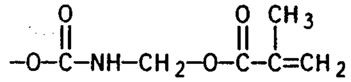 ,

III-2 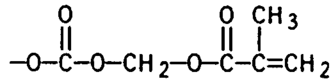 ,

III-3 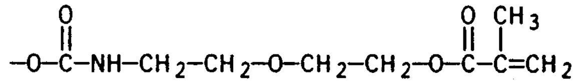 ,

III-4 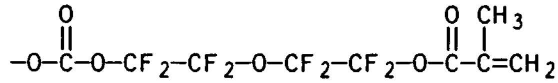 ,

III-5 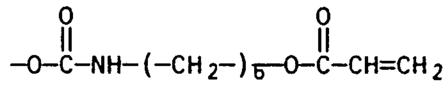 ,

III-6 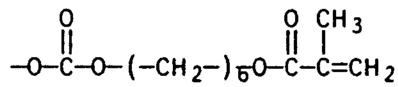 und

III-7 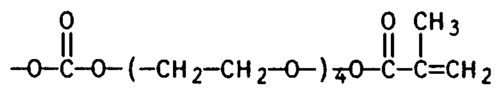 .

Weitere Beispiele besonders gut geeigneter Substituenten, welche eine photopolymerisierbare olefinisch ungesättigte Gruppe aufweisen sind die Substituenten IV bis X:

IV 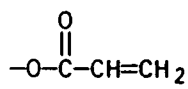 ,

V 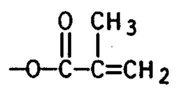 ,

VI 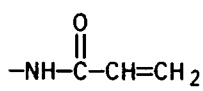 ,

VII 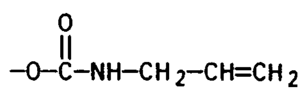 ,

VIII 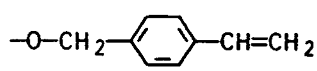 ,

IX 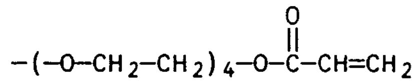 und

X 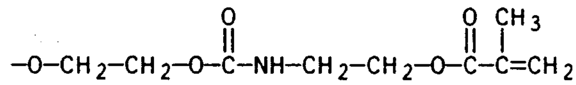 .

Von diesen sind die Substituenten III-3 und V ganz besonders gut geeignet.

Beispiele gut geeigneter substituierter Benzophenone ($b_4$) sind die substituierten Benzophenone ($b_{41}$) bis ($b_{418}$).

($b_{41}$) 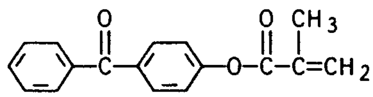 ,

($b_{42}$) 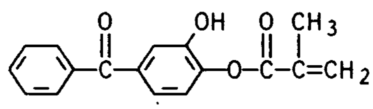 ,

($b_{43}$) 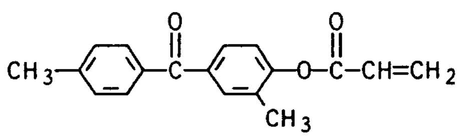 ,

($b_{44}$) 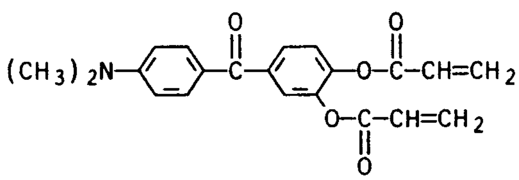 ,

($b_{45}$) 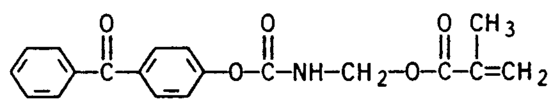 ,

($b_{46}$) 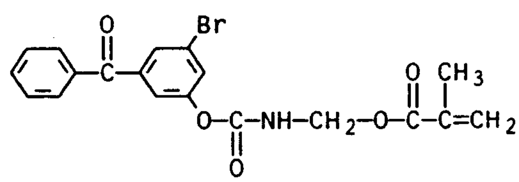 ,

($b_{47}$) 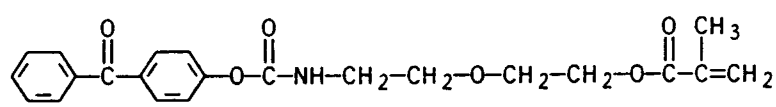 ,

($b_{48}$) 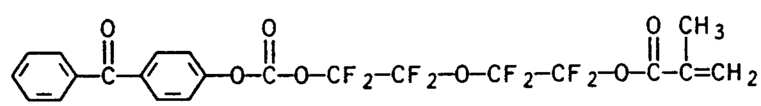 ,

($b_{49}$) 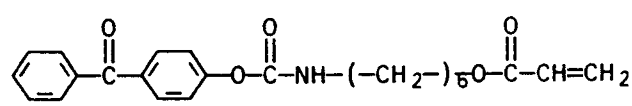 ,

($b_{410}$) 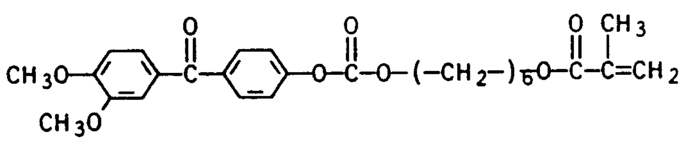

($b_{411}$) 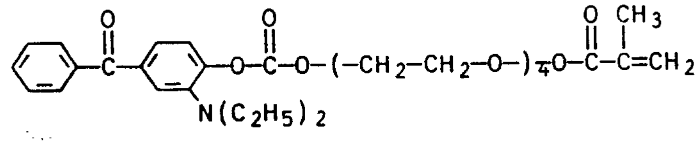

($b_{412}$) 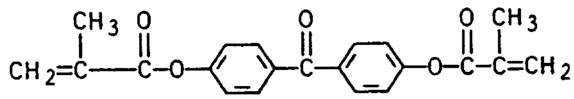 ,

($b_{413}$) 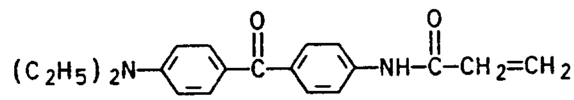 ,

($b_{414}$) 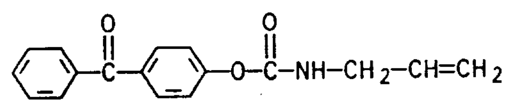 ,

($b_{415}$) 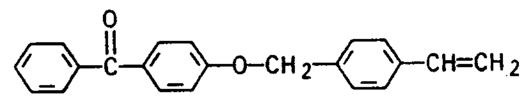 ,

($b_{416}$) 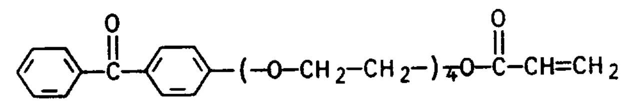 und

($b_{417}$) 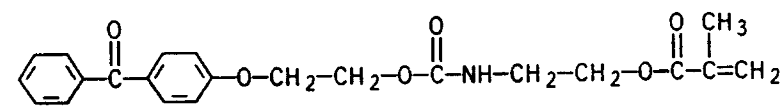 .

Von diesen sind die substituierten Benzophenone ($b_{41}$) und ($b_{47}$) ganz besonders gut geeignet.

Die substituierten Benzophenone ($b_4$) sind an sich bekannte Verbindungen, deren Herstellung und Eigenschaften in der deutschen Patentanmeldung P 38 20 463.0, der EP-A-0 246 848, der US-A-3 214 492, der US-A-3 429 852, der DE-A-28 18 763 und der US-A-3 322 818 beschrieben werden.

Die erfindungsgemäß zu verwendende photopolymerisierbare reliefbildende Aufzeichnungsschicht (B) enthält außerdem mindestens ein polymeres Bindemittel ($b_1$) in einer Menge von, bezogen auf (B), 40 bis 99, vorzugsweise 60 bis 98 und insbesondere 70 bis 95 Gew.-%. Als polymere Bindemittel ($b_1$) kommen grundsätzlich alle Polymeren in Betracht, wie sie üblicherweise in photopolymerisierbaren reliefbildenden Aufzeichnungsschichten verwendet werden.

Besonders gut geeignet sind hierbei Elastomere.

Beispiele besonders gut geeigneter elastomerer polymerer Bindemittel ($b_1$) sind die bekannten Polyalkadiene, Vinylaromat/Alkadien-Copolymersiate und -Blockmischpolymerisate, Alkadien/Acrylnitril-Copolymerisate, Ethylen/Propylen-Copolymerisate, Ethylen/Propylen/Alkadien-Copolymerisate, Ethylen/Acrylsäure-Copolymerisate, Alkadien/Acrylsäure-Copolymerisate, Alkadien/Acrylat/Acrylsäure-Copolymerisate und Ethylen/(Meth)Acrylsäure/-(Meth)Acrylat-Copolymerisate.

Ganz besonders gut geeignet sind Elastomere, welche konjugierte Alkadiene wie Butadien oder Isopren einpolymerisiert enthalten.

Des weiteren enthält die erfindungsgemäß zu verwendende photopolymerisierbare reliefbildende Aufzeichnungsschicht (B) übliche und bekannte photopolymerisierbare olefinisch ungesättigte Monomere ($b_2$), welche mit den polymeren Bindemitteln ($b_1$) verträglich sind, in einer Menge von 1 bis 60, vorteilhafterweise 2 bis 50, und insbesondere 3 bis 40 Gew.-%, bezogen auf (B). Die Bezeichnung "verträglich" zeigt an, daß die betreffenden Monomere ($b_2$) mit dem polymeren Bindemittel ($b_1$) so gut abmischbar sind, daß in der betreffenden photopolymerisierbaren reliefbildenden Aufzeichnungsschicht (B) keine Trübungen oder Schlieren hervorgerufen werden. Beispiele geeigneter Monomerer ($b_2$) sind die üblichen und bekannten Acrylate und die Methacrylate von ein- und mehrwertigen Alkoholen, Acryl- und Methacrylamide, Vinylether und Vinylester, Allylether und Allylester sowie Fumar- oder Maleinsäurediester.

Darüber hinaus enthält die erfindungsgemäß zu verwendende photopolymerisierbare reliefbildende Aufzeichnungsschicht (B) mindestens einen üblichen und bekannten Photopolymerisationsinitiator ($b_3$) in einer Menge von 0,01 bis 10, vorzugsweise 0,5 bis 5 und insbesondere 0,1 bis 2 Gew.-%, bezogen auf (B). Beispiele geeigneter Photopolymerisationsinitiatoren ($b_3$) sind Benzoin oder Benzoinderivate wie dessen Methyl-, Isopropyl-, n-Butyl- und Isobutylether; symmetrisch und unsymmetrisch substituierte Benzilacetale wie Benzildimethylacetal, Benzil-1-methyl-1-ethylacetal; und Acylarylphosphinoxide und deren Derivate wie 2,6-Dimethoxibenzoyl-diphenyl-phosphinoxid, 2,4,6-Trimethylbenzoyl-diphenylphosphinoxid, 2,4,6-Trimethylbenzoyl-phenylphosphinsäureethylester und 2,4,6-Trimethylbenzoyl-phenylphosphinsäure-natriumsalz; und Hydroxypropanone wie 1-Phenyl-2-methyl-2-hydroxy-1-propanon, 1-(4-Isopropyl)-phenyl-2-methyl-2-hydroxy-1-propanon; und 1-Hydroxycyclohexylphenylketon, von denen die Benzoin- und Benzilderivate besonders gut geeignet sind.

Darüber hinaus kann die erfindungsgemäß zu verwendende photopolymerisierbare reliefbildende Aufzeichnungsschicht (B) weitere Zusatzstoffe wie etwa Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Füllstoffe und/oder Verstärkerfüllstoffe in wirksamen Mengen enthalten.

Die Herstellung der erfindungsgemäß zu verwendenden photopolymerisierbaren reliefbildenden Aufzeichnungsschicht (B) aus ihren Bestandteilen erfolgt im allgemeinen durch Mischen der Bestandteile mit Hilfe bekannter Mischmethoden und durch Verarbeiten der Mischung zu der Aufzeichnungsschicht (B) mit Hilfe bekannter Techniken wie Gießen aus Lösung, Kalandrieren oder Extrudieren, wobei diese Maßnahmen auch in geeigneter Weise miteinander kombiniert werden können.

Die Stärke der erfindungsgemäß zu verwendenden photopolymerisierbaren reliefbildenden Aufzeichnungsschicht (B) beträgt zweckmäßigerweise 200 $\mu$m bis 1 cm und insbesondere 300 $\mu$m bis 3 mm.

Der weitere wesentliche Bestandteil des erfindungsgemäßen Aufzeichnungselements ist der dimensionsstabile Träger (A). Beispiele geeigneter dimensionsstabiler Träger (A) sind Platten, Folien und konische und zylindrische Röhren (sleeves) aus Metallen wie Stahl, Aluminium, Kupfer oder Nickel oder aus Kunststoffen wie Polyethylenterephthalat, Polybutylenterephthalat, Polyamid und Polycarbonat, Gewebe und Vliese wie Glasfasergewebe sowie Verbundmaterialien aus Glasfasern und Kunststoffen.

Darüber hinaus kann das erfindungsgemäße lichtempfindliche Aufzeichnungselement weitere Schichten enthalten. So kann der dimensionsstabile Träger (A) mit einer weichelastischen Unterschicht gemäß der DE-A-24 44 118 unterlegt sein. Desweiteren kann sich auf der dem dimensionsstabilen Träger (A) abgewandten Seite der photopolymerisierbaren reliefbildenden Aufzeichnungsschicht (B) eine übliche und bekannte Deckschicht (C) und/oder eine übliche und bekannte Deckfolie (D) befinden. Werden die Deckschicht (C) und die Deckfolie (D) gemeinsam verwendet, dann liegt die Deckschicht (C) der photopolymerisierbaren reliefbildenden Aufzeichnungsschicht (B) direkt auf, und es kann sich außerdem zwischen der Deckschicht (C) und der Deckfolie (D) noch eine Antihaftschicht befinden. Ferner kann eine haftfeste Verbindung zwischen dem dimensionsstabilen Träger (A) und der photopolymerisierbaren reliefbildenden Aufzeichnungsschicht (B) mit Hilfe einer Haftlackschicht hergestellt werden.

Im allgemeinen liegt die Stärke der Haftlackschichten bei 0,5 bis 4 $\mu$m, die Stärke der Deckschichten (C) bei 0,5 bis 20 $\mu$m, die Stärke der Deckfolien (D) bei 20 bis 150 $\mu$m und die Stärke der Antihaftschichten bei 0,1 bis 0,5 $\mu$m.

Die Herstellung des erfindungsgemäßen Aufzeichnungselements weist keine methodischen Besonderheiten auf, sondern erfolgt durch Auftragen der erfindungsgemäß zu verwendenden photopolymerisierbaren reliefbildenden Aufzeichnungsschicht (B) auf den dimensionsstabilen Träger (A) mittels Gießen aus Lösung, Heißpressen, Kalandrieren oder Extrudieren. Auf dieses Zweischichtenelement können dann die anderen Schichten in bekannter Weise aufgebracht werden. Es ist aber auch möglich, die erfindungsgemäß zu verwendende photopolymerisierbare reliefbildende Aufzeichnungsschicht (B) zunächst auf die mit einer Deckschicht (C) bedeckten Seite einer Deckfolie (D) aufzutragen und im Anschluß daran die unbedeckte Seite der photopolymerisierbaren reliefbildenden Aufzeichnungsschicht (B) mit dem dimensionsstabilen Träger (A) haftfest zu verbinden.

Bei dem erfindungsgemäßen Verfahren wird das erfindungsgemäße Aufzeichnungselement im Verfahrensschritt (1) mit aktinischem Licht bildmäßig belichtet. Beispiele geeigneter Lichtquellen für aktinisches Licht sind die üblichen und bekannten Quecksilberhoch-, -mittel- oder -niederdruckstrahler, UV-Fluoreszenzröhren oder mit Metallhalogeniden dotierten Lampen.

Im Anschluß daran werden die unbelichteten und daher nicht photopolymerisierten Bereiche der bildmäßig belichteten reliefbildenden Aufzeichnungsschicht (B) mit einem geeigneten Entwicklerlösungsmittel ausgewaschen bzw. entwickelt. Beispiele geeigneter Entwicklungslösungsmittel sind die üblichen und bekannten unpolaren, aprotisch polaren und protisch polaren Lösungsmittel sowie deren Gemische, wie sie

üblicherweise für den genannten Zweck verwendet werden. Im allgemeinen wird der Verfahrensschritt (2) in den üblichen und bekannten Sprüh-, Reibe- und Bürstenwaschern durchgeführt.

Im Anschluß an den Verfahrensschritt (2) wird die hierbei resultierende photopolymerisierte Reliefschicht mit aktinischem Licht einer Wellenlänge $\lambda \leqq 300$ nm, insbesondere 200 bis 300 nm, nachbelichtet bzw. nachbehandelt.

Beispiele geeigneter Lichtquellen für aktinisches Licht dieser Wellenlänge sind die üblichen und bekannten Entkeimungs- bzw. Sterilisationslampen.

Das erfindungsgemäße Verfahren kann weitere Verfahrensschritte umfassen. Beispiele geeigneter weiterer Verfahrensschritte sind

- das vollflächige Vorbelichten des erfindungsgemäßen Aufzeichnungselements mit aktinischem Licht von seiner Vorder- und/oder Rückseite her,
- das Abziehen der gegebenenfalls in dem erfindungsgemäßen Aufzeichnungselement vorhandenen Deckfolie (D),
- das separate Auswaschen der gegebenenfalls in dem bildmäßig belichteten Aufzeichnungselement vorhandenen Deckschicht (C),
- das Trocknen und/oder das Ruhenlassen der photopolymerisierten Reliefschicht vor der Durchführung des Verfahrensschritts (3) und
- das vollflächige Nachbelichten der photopolymerisierten Reliefschicht mit aktinischem Licht einer Wellenlänge $\lambda \geqq 300$ nm nach dem Verfahrensschritt (3).

Das erfindungsgemäße Verfahren weist zahlreiche besondere Vorteile auf.

So kann das erfindungsgemäße Verfahren nicht nur zur Herstellung von Reliefdruckplatten mit klebfreier druckender Oberfläche verwendet werden, sondern auch für die Herstellung von klebfreien dekorativen Reliefformen. Indes sind die besonderen Vorteile des erfindungsgemäßen Verfahrens für die Herstellung von flexographischen Reliefdruckplatten von ganz herausragender Bedeutung, weil sich bei diesem Verwendungszweck die Oberflächenklebrigkeit ganz besonders störend bemerkbar macht. Hier liefert das erfindungsgemäße Verfahren flexographische Reliefdruckplatten, deren elastomere photopolymerisierte Reliefschicht eine klebfreie druckende Oberfläche hat. Bedingt durch die stoffliche Zusammensetzung des erfindungsgemäßen Aufzeichnungselements bzw. seiner photopolymerisierbaren reliefbildenden Aufzeichnungsschicht (B) ist die Zeit für die Nachbelichtung mit aktinischem Licht einer Wellenlänge $\lambda \leqq 300$ nm bei dem erfindungsgemäßen Verfahren geringer als bei den Verfahren des Standes der Technik, was für die betriebliche Praxis ein bedeutungsvoller Fortschritt ist. Außerdem neigen die in erfindungsgemäßer Verfahrensweise hergestellten flexographischen Reliefdruckplatten bzw. deren photopolymerisierte Reliefschichten nicht zur Versprödung und zur Rißbildung bei der Nachbehandlung oder bei längerer Lagerung und/oder Dauergebrauch. Daher sind die in erfindungsgemäßer Verfahrensweise hergestellten flexographischen Reliefdruckplatten erheblich öfter und länger im Flexodruck verwendbar als die nach den Verfahren des Standes der Technik hergestellten und liefern demnach auch eine sehr viel höhere Auflage an ausgezeichneten Drucken. Hinzu kommt noch, daß die in erfindungsgemäßer Verfahrensweise hergestellten flexographischen Reliefdruckplatten eine vorzügliche Farbannahme aufweisen, dabei aber gegenüber den Druckfarbenlösungsmitteln ausgesprochen stabil sind und von diesen nicht in einem störenden Ausmaß angequollen werden.

Beispiele und Vergleichsversuche

Für die nachfolgend beschriebenen Beispiele 1 bis 6 und die Vergleichsversuche V1 bis V14 wurden photopolymerisierbare reliefbildende Aufzeichnungsschichten (B) der in der Tabelle 1 angegebenen Zusammensetzung verwendet. Hierbei wurden in allen Fällen

- als polymeres Bindemittel ($b_1$) ein übliches und bekanntes thermoplastisches elastomeres Styrol/Isopren/(Styrol-Butadien)-Dreiblockmischpolymerisat,
- als photopolymerisierbares olefinisch ungesättigtes Monomeres ($b_2$) Hexan-1,6-diol-diacrylat,
- als Photopolymerisationsinitiator ($b_3$) Benzildimethylacetal;
- als weitere lichtempfindliche Verbindung ($b_4$) entweder Benzophenon ($b_{40}$) oder das substituierte Benzophenon ($b_{41}$) oder das substituierte Benzophenon ($b_{47}$)

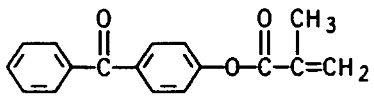

(b41)

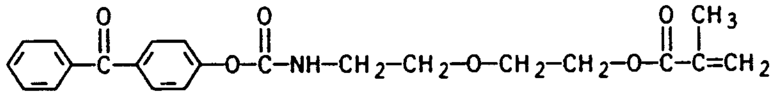

(b47)

sowie

- als Hilfsstoffe, jeweils bezogen auf die photopolymerisierbare reliefbildende Aufzeichnungsschicht (B), 1,2 Gew.-% 2,6-Di-tert.-butyl-p-kresol, 0,008 Gew.-% des Farbstoffs Solvent Black (C.I. 26150) und 5 Gew.-% eines üblichen und bekannten Paraffinöls als Weichmacher, was zusammen 6,208 Gew.-% der Aufzeichnungsschicht (B) ausmacht,

verwendet.

Bei den Beispielen und Vergleichsversuchen wurde für die bildmäßige Belichtung mit aktinischem Licht (Verfahrensschritt 1) ein übliches und bekanntes Standardnegativ und ein üblicher und bekannter Röhrenflachbelichter verwendet.

Die Entwicklung der bildmäßig belichteten reliefbildenden Aufzeichnungsschichten (B) (Verfahrensschritt 2) wurde in einem üblichen und bekannten Bürstenrundwascher durchgeführt. Hierbei wurden als Entwicklerlösungsmittel

- ein Gemisch aus 80 Vol.-% Tetrachlorethylen und 20 Vol.-% n-Butanol (Entwicklerlösungsmittel 1) und
- ein Gemisch aus 80 Vol.-% einer hochsiedenden hydrierten Erdölfaktion (Exxsol® D 60 von ESSO) und 20 Vol.-% n-Pentanol (Entwicklerlösungsmittel 2)

verwendet.

Für die Nachbelichtung (Nachbehandlung) mit aktinischem Licht einer Wellenlänge $\lambda \leqq 300$ nm (Verfahrensschritt 3) wurde eine Lampennachbehandlungslage von Anderson und Vreeland, Größe 300 x 400 mm, Röhrentyp: Philips TUV 40 W verwendet.

Für die Nachbehandlung mit Brom wurde ein übliches und bekanntes Tauchbad verwendet.

Die Klebrigkeit der druckenden Oberfläche der photopolymerisierten Reliefschichten der flexographischen Reliefdruckplatten wurde mit Hilfe der Pendelmethode ermittelt. Hierzu wurden aus den photopolymerisierten Reliefschichten Volltonflächen herausgeschnitten und an diesen Proben die Pendelklebrigkeitswerte bestimmt. Hierbei wird bekanntermaßen ein mit einem Pendel verbundener Zylinder auf die betreffende Oberfläche aufgelegt und nach einer bestimmten Auslenkung des Pendels die Zahl der Schwingungen bis zum Stillstand des Pendels gemessen. Je klebriger die betreffende Oberfläche ist, um so stärker wird die Schwingung des Pendel gedämpft und um so geringere Pendelklebrigkeitswerte werden erhalten.

Beispiele 1 bis 6 und Vergleichsversuche V1 bis V4

Die Herstellung flexographischer Reliefdruckplatten in erfindungsgemäßer (Beispiele 1 bis 6) und in nicht erfindungsgemäßer (Vergleichsversuche V1 bis V4) Verfahrensweise;

Versuchsvorschrift:

Die für die Durchführung der Beispiele 1 bis 6 und der Vergleichsversuche V1 bis V4 verwendeten lichtempfindlichen Aufzeichnungselemente hatten eine Gesamtstärke von 2840 µm und bestanden jeweils aus einer 2700 µm starken photopolymerisierbaren reliefbildenden Aufzeichnungsschicht (B) und einer 140 µm starken, mit einem Polyurethanhaftlack beschichteten Polyethylenterephthalatfolie als dimensionsstabilem Träger (A).

Die Tabelle 1 gibt die stoffliche Zusammensetzung der jeweils verwendeten photopolymerisierbaren reliefbildenden Aufzeichnungsschicht (B) und die Verfahrensbedingungen, welche bei der weiteren Verarbeitung der lichtempfindlichen Aufzeichnungselemente angewandt wurden, wieder.

Die mit Hilfe der Pendelmethode gemessenen Klebrigkeitswerte sind in der Tabelle 2 zusammengestellt.

Vergleichsversuche V5 bis V14

Die Herstellung flexographischer Reliefdruckplatten nach einem nicht erfindungsgemäßen Verfahren, welches die Nachbehandlung der Oberfläche der photopolymerisierten Reliefschicht mit einer bromhaltigen Lösung umfaßt;

Versuchsvorschrift:

Die Beispiele 1 bis 6 sowie die Vergleichsversuche V1 bis V4 wurden wiederholt, nur daß anstelle des Nachbelichtens der photopolymerisierten Reliefschichten mit aktinischem Licht einer Wellenlänge $\lambda \leqq 300$ nm (Verfahrensschritt 3) eine übliche und bekannte Nachbehandlung mit einer bromhaltigen Lösung durchgeführt wurde. Hierbei lag die Kontaktzeit einheitlich bei 5 min.

Die mit Hilfe der Pendelmethode ermittelten Klebrigkeitswerte der in dieser Weise hergestellten flexographischen Reliefdruckplatten werden in der Tabelle 2 den Werten der Beispiele 1 bis 6 und den Werten der Vergleichsversuche V1 bis V4 gegenübergestellt. Hierbei können

- Beispiel 1 und Vergleichsversuch V5,
- Beispiel 2 und Vergleichsversuch V6,
- Beispiel 3 und Vergleichsversuch V7,
- Beispiel 4 und Vergleichsversuch V10,
- Beispiel 5 und Vergleichsversuch V11,
- Beispiel 6 und Vergleichsversuch V12,
- Vergleichsversuch V1 und Vergleichsversuch V8,
- Vergleichsversuch V2 und Vergleichsversuch V13,
- Vergleichsversuch V3 und Vergleichsversuch V9 sowie
- Vergleichsversuch V4 und Vergleichsversuch V14

direkt miteinander verglichen werden.

Tabelle 1: Zusammensetzung der photopolymerisierbaren reliefbildenden Aufzeichnungsschicht (B) der erfindungsgemäßen (Beispiele 1 bis 6) und der nicht erfindungsgemäßen (Vergleichsversuche V1 bis V4) lichtempfindlichen Aufzeichnungselemente und ihre Weiterverarbeitung zu flexographischen Reliefdruckplatten in erfindungsgemäßer (Beispiele 1 bis 6) und nicht erfindungsgemäßer (Vergleichsversuche V1 bis V14) Verfahrensweise

| Bsp. | Zusammensetzung (in Gew.-%) Bindemittel $b_1$ | Monomer $b_2$ | Photopolymerisationsinitiator $b_3$ | (substituiertes) Benzophenon $b_4$ | Hilfsstoffe | Vorbelichtung mit aktinischem Licht (s) | bildmässige Belichtung mit aktinischem Licht (min) | Entwicklungszeit (min) | Entwicklerlösungsmittel Nr. | Nachbehandlung mit Licht ($\lambda \leq 300$ nm) (min) | Bromnachbehandlung (min) |
|---|---|---|---|---|---|---|---|---|---|---|---|
| 1 | (86,492) | (5) | (1,2) | $b_{41}$ (1,1) | (6,208) | 65 | 13 | 6 | 1 | 15 | - |
| 2 | (85,592) | (5) | (1,2) | $b_{47}$ (2,0) | (6,208) | 70 | 12 | 6 | 1 | 15 | - |
| 3 | (86,392) | (5) | (1,2) | $b_{40}$ (1,2) | (6,208) | 70 | 18 | 6 | 1 | 15 | - |
| 4 | Zusammensetzung wie Beispiel 1 | | | | | 65 | 13 | 9 | 2 | 20 | - |
| 5 | Zusammensetzung wie Beispiel 2 | | | | | 73 | 12 | 9 | 2 | 20 | - |
| 6 | Zusammensetzung wie Beispiel 3 | | | | | 70 | 18 | 9 | 2 | 20 | - |
| Vgl. Vers. | | | | | | | | | | | |
| V1 | (87,592) | (5) | (1,2) | - | (6,208) | 67 | 12 | 6 | 1 | 15 | - |
| V2 | Zusammensetzung wie Vgl.vers. V1 | | | | | 65 | 13 | 9 | 2 | 20 | - |
| V3 | (87,592) | (5) | - | $b_{40}$ (1,2) | (6,208) | 400 | > 30 | 6 | 1 | 15 | - |

Tabelle 1 (Fortsetzung)

| Bsp. | Zusammensetzung (in Gew.-%) Bindemittel $b_1$ | Monomer $b_2$ | Photopolymerisationsinitiator $b_3$ | (substituiertes) Benzophenon $b_4$ | Hilfsstoffe | Vorbelichtung mit aktinischem Licht (s) | bildmässige Belichtung mit aktinischem Licht (min) | Entwicklungszeit (min) | Entwicklerlösungsmittel Nr. | Nachbehandlung mit Licht (λ ≤300 nm) (min) | Bromnachbehandlung (min) |
|---|---|---|---|---|---|---|---|---|---|---|---|
| Vgl. Vers. | | | | | | | | | | | |
| V4 | Zusammensetzung wie Vgl.vers. V3 | | | | | 400 | > 30 | 9 | 2 | 15 | - |
| V5 | Zusammensetzung wie Beispiel 1 | | | | | 65 | 13 | 6 | 1 | - | 5 |
| V6 | Zusammensetzung wie Beispiel 2 | | | | | 70 | 12 | 6 | 1 | - | 5 |
| V7 | Zusammensetzung wie Beispiel 3 | | | | | 70 | 18 | 6 | 1 | - | 5 |
| V8 | Zusammensetzung wie Vgl.Vers. V1 | | | | | 67 | 12 | 6 | 1 | - | 5 |
| V9 | Zusammensetzung wie Vgl.Vers. V3 | | | | | 400 | > 30 | 6 | 1 | - | 5 |
| V10 | Zusammensetzung wie Beispiel 1 | | | | | 65 | 13 | 9 | 2 | - | 5 |
| V11 | Zusammensetzung wie Beispiel 2 | | | | | 73 | 12 | 9 | 2 | - | 5 |
| V12 | Zusammensetzung wie Beispiel 3 | | | | | 70 | 18 | 9 | 2 | - | 5 |
| V13 | Zusammensetzung wie Vgl.Vers. V1 | | | | | 65 | 13 | 9 | 2 | - | 5 |
| V14 | Zusammensetzung wie Vgl.Vers. V3 | | | | | 400 | > 30 | 9 | 2 | - | 5 |

Tabelle 2

| Die Pendelklebrigkeit der druckenden Oberfläche der photopolymerisierten Reliefschichten der flexographischen Reliefdruckplatten | |
|---|---|
| Beispiel Nr. | Pendelklebrigkeitswerte |
| | nach der Nachbehandlung mit Licht |
| 1 | 54 |
| 2 | 72 |
| 3 | 60 |
| 4 | 49 |
| 5 | 59 |
| 6 | 51 |
| Vergl.Vers. | |
| V1 | 14 |
| V2 | 8 |
| V3 | nicht meßbar, zu klebrig, zu schlecht ausgebildetes Relief |
| V4 | nicht meßbar, zu klebrig, zu schlecht ausgebildetes Relief |
| | nach der Bromnachbehandlung |
| V5 | 56 |
| V6 | 57 |
| V7 | 48 |
| V8 | 55 |
| V9 | nicht meßbar, zu klebrig, zu schlecht ausgebildetes Relief |
| V10 | 48 |
| V11 | 52 |
| V12 | 45 |
| V13 | 50 |
| V14 | nicht meßbar, zu klebrig, zu schlecht ausgebildetes Relief |

Was beim Vergleich der Pendelklebrigkeitswerte der Tabelle 2 sofort ins Auge springt, ist die Tatsache, daß Benzophenon ($b_{40}$) für sich alleine nicht oder nur sehr schlecht als Photopolymerisationsinitiator wirksam war. Dies ging unzweifelhaft aus den Vergleichsversuchen V3 und V9 sowie V4 und V14 hervor. Die hierfür verwendeten Aufzeichnungsschichten (B) lieferten trotz drastisch verlängerter Vorbelichtung und bildmäßiger Belichtung nur sehr schlecht ausgebildete Reliefschichten, die zudem noch stark klebrig waren, so daß ihre Pendelklebrigkeit nicht ermittelt werden konnte.

Wie der Vergleich der in der Tabelle 2 zusammengefaßten Pendelklebrigkeitswerte außerdem zeigt, konnte die Oberfläche der photopolymerisierten Reliefschicht der bekannten flexographischen Reliefdruckplatten (Vergleichsversuche V1 und V2) nicht in der kurzen Zeit entklebt werden, wie dies bei der Oberfläche der photopolymerisierten Reliefschichten der erfindungsgemäßen flexographischen Reliefdruckplatten (Beispiele 1 bis 6) der Fall war. Schon gar nicht erreicht die Oberfläche der photopolymerisierten Reliefschichten der bekannten flexographischen Reliefdruckplatten (Vergleichsversuche V1 und V2) die Klebfreiheit, wie sie mit Hilfe der üblichen und bekannten Bromnachbehandlungsmethode (Vergleichsversuche V8 und V13) erzielt wurde. Dagegen war die Oberfläche der photopolymerisierten Reliefschichten der in erfindungsgemäßer Verfahrensweise hergestellten erfindungsgemäßen flexographischen Reliefdruckplatten (Beispiele 1 bis 6) hinsichtlicht der Klebfreiheit von besserer Qualität, als die Oberfläche der photopolymerisierten Reliefschichten der erfindungsgemäßen Reliefdruckplatten, welche in üblicher und bekannter Weise mit einer bromhaltigen Lösung nachbehandelt worden waren (Vergleichsversuche V5 bis V7 und V10 bis V12). Dieser besondere technische Effekt des erfindungsgemäßen Verfahrens und des hierfür verwendeten erfindungsgemäßen Aufzeichnungselements wurde erzielt, ohne daß dabei die Nachteile in Kauf genommen werden müssen, welche bekanntermaßen mit der Verwendung der hochkorrosiven Bromlösungen verbunden sind.

Ferner ergeben sich aus dem Vergleich der Pendelklebrigkeitswerte der Tabelle 2 Hinweise auf gewisse Abstufungen innerhalb der Beispiele 1 bis 6. So war bei den Beispielen 4 bis 6, bei welchen das Entwicklerlösungsmittel 2 verwendet worden war, eine etwas längere Nachbehandlung mit Licht einer

Wellenlänge λ ≦ 300 nm notwendig, um den gleichen hervorragenden Verfahrenserfolg wie bei den Beispielen 1 bis 3 zu erzielen.

Außerdem war bei der Verwendung von Benzophenon ($b_{40}$) als weiterer lichtempfindlicher Verbindung ($b_4$) (Beispiele 3 und 6) eine längere Zeit für die bildmäßige Belichtung notwendig als bei den Beispielen 1, 2, 4 und 5.

Ferner wurde bei der Entwicklung etwas Benzophenon ($b_{40}$) mitausgewaschen (Beispiele 3 und 6), was bei den substituierten Benzophenonen ($b_{41}$) und ($b_{47}$) nicht der Fall war.

Insgesamt waren aber die in erfindungsgemäßer Verfahrensweise aus den erfindungsgemäßen Aufzeichnungselementen hergestellten erfindungsgemäßen flexographischen Reliefdruckplatten der Beispiele 1 bis 6 sowohl in ihrer Oberflächenqualität als auch in ihrem Druckverhalten den flexographischen Reliefdruckplatten der Vergleichsversuche V5 bis V8 und V10 bis V13 eindeutig und den flexographischen Reliefdruckplatten der Vergleichsversuche V1 und V2 weit überlegen. Die Verfahrensprodukte der Vergleichsversuche V3 und V9 sowie V4 und V14 waren überhaupt nicht für den Flexodruck verwendbar.

## Patentansprüche

**1.** Lichtempfindliches Aufzeichnungselement für die Herstellung von Reliefdruckplatten mit klebfreier druckender Oberfläche, welches
A) einen dimensionsstabilen Träger und
B) eine photopolymerisierbare reliefbildende Aufzeichnungsschicht mit
$b_1$) mindestens einem polymeren Bindemittel,
$b_2$) mindestens einem photopolymerisierbaren olefinisch ungesättigten Monomeren, welches mit dem polymeren Bindemittel ($b_1$) verträglich ist,
$b_3$) mindestens einem Photopolymerisationsinitiator und mit
$b_4$) mindestens einer weiteren lichtempfindlichen Verbindung
enthält, dadurch gekennzeichnet, daß die weitere lichtempfindliche Verbindung ($b_4$) Benzophenon und/oder ein ein- oder mehrfach substituiertes Benzophenon ist, welches in seinem Substituenten oder in mindestens einem seiner Substituenten mindestens eine photopolymerisierbare olefinisch ungesättigte Gruppe aufweist.

**2.** Das lichtempfindliche Aufzeichnungselement nach Anspruch 1, dadurch gekennzeichnet, daß der betreffende Substituent eine photopolymerisierbare olefinisch ungesättigte Gruppe aufweist.

**3.** Das lichtempfindliche Aufzeichnungselement nach Anspruch 1 oder 2, dadurch gekennzeichnet, daß das substituierte Benzophenon ($b_4$) einen Substituenten aufweist.

**4.** Das lichtempfindliche Aufzeichnungselement für die Herstellung flexographischer Reliefdruckplatten nach einem der Ansprüche 1 bis 3, dadurch gekennzeichnet, daß das polymere Bindemittel ($b_1$) ein Elastomer ist.

**5.** Das lichtempfindliche Aufzeichnungselement für die Herstellung flexographischer Reliefdruckplatten nach Anspruch 4, dadurch gekennzeichnet, daß das elastomere polymere Bindemittel ($b_1$) konjugierte Alkadiene einpolymerisiert enthält.

**6.** Verfahren zur Herstellung einer Reliefdruckplatte, deren photopolymerisierte Reliefschicht eine klebfreie druckende Oberfläche hat, durch
(1) bildmäßiges Belichten eines lichtempfindlichen Aufzeichnungselements, welches einen dimensionsstabilen Träger (A) und eine photopolymerisierbare reliefbildende Aufzeichnungsschicht (B) enthält, mit aktinischem Licht,
(2) Auswaschen (Entwickeln) der unbelichteten und daher nicht photopolymerisierten Bereiche der bildmäßig belichteten reliefbildenden Aufzeichnungsschicht mit einem Entwicklerlösungsmittel und
(3) Nachbelichten (Nachbehandeln) der in dieser Weise erhaltenen photopolymerisierten Reliefschicht mit Licht einer Wellenlänge λ ≦ 300 nm,
dadurch gekennzeichnet, daß man hierbei ein lichtempfindliches Aufzeichnungselement gemäß einem der Ansprüche 1 bis 5 verwendet.

## Claims

1. A light-sensitive recording element for producing relief printing plates having a tack-free printing surface, comprising
   A) a dimensionally stable base material and
   B) a photopolymerizable relief-forming recording layer with
      $b_1$) at least one polymeric binder,
      $b_2$) at least one photopolymerizable olefinically unsaturated monomer which is compatible with the polymeric binder ($b_1$),
      $b_3$) at least one photopolymerization initiator and
      $b_4$) at least one further light-sensitive compound,
   wherein ($b_4$) is benzophenone and/or a monosubstituted or polysubstituted benzophenone which has in its substituent, or in at least one of its substituents, at least one photopolymerizable olefinically unsaturated group.

2. The light-sensitive recording element as claimed in claim 1, wherein the substituent in question contains a photopolymerizable olefinically unsaturated group.

3. The light-sensitive recording element as claimed in claim 1 or 2, wherein the substituted benzophenone ($b_4$) has one substituent.

4. The light-sensitive recording element for producing flexographic relief printing plates as claimed in any of claims 1 to 3, wherein the polymeric binder ($b_1$) is an elastomer.

5. The light-sensitive recording element for producing flexographic relief printing plates as claimed in claim 4, wherein the elastomeric polymeric binder ($b_1$) contains a conjugated alkadiene as copolymerized units.

6. A process for producing a relief printing plate whose photopolymerized relief layer has a non-tacky printing surface by
   (1) subjecting a light-sensitive recording element comprising a dimensionally stable base material (A) and a photopolymerizable relief-forming recording layer (B) to imagewise exposure with actinic light,
   (2) washing out (developing) the unexposed and hence unphotopolymerized areas of the imagewise-exposed relief-forming recording layer with a developer and
   (3) afterexposing (aftertreating) the resulting photopolymerized relief layer to light of a wavelength $\lambda \leq 300$ nm,
   which comprises using a light-sensitive recording element as claimed in any of claims 1 to 5.

## Revendications

1. Elément d'enregistrement photosensible pour la fabrication de plaques d'impression en relief à surface imprimante non collante, qui contient
   A) un support à dimensions stables, et
   B) une couche d'enregistrement photopolymérisable formant le relief comprenant :
      b1) au moins un liant polymère,
      b2) au moins un monomère à insaturation oléfinique photopolymérisable compatible avec le liant polymère b1),
      b3) au moins un inducteur de photopolymérisation, et
      b4) au moins un autre composé photosensible,
   caractérisé en ce que l'autre composé photosensible b4) consiste en la benzophénone et/ou une benzophénone à un ou plusieurs substituants, laquelle contient, dans son substituant ou dans au moins un de ses substituants, au moins un groupe à insaturation oléfinique photopolymérisable.

2. L'élément d'enregistrement photosensible selon la revendication 1, caractérisé en ce que le substituant en question contient un groupe à insaturation oléfinique photopolymérisable.

3. L'élément d'enregistrement photosensible selon la revendication 1 ou 2, caractérisé en ce que la benzophénone substituée b4) a un substituant.

**4.** L'élément d'enregistrement photosensible pour la fabrication de plaques d'impression flexographiques en relief selon une des revendications 1 à 3, caractérisé en ce que le liant polymère b1) est un élastomère.

**5.** L'élément d'enregistrement photosensibe pour la fabrication de plaques d'impression flexographiques en relief selon la revendication 4, caractérisé en ce que le liant polymère élastomère b1) contient des alcadiènes conjugués à l'état polymérisé.

**6.** Procédé pour la préparation d'une plaque d'impression en relief dont la couche de relief photopolymérisée a une surface imprimante non collante, par

(1) exposition à la lumière actinique avec formation d'une image, d'un élément d'enregistrement photosensible contenant un support à dimensions stables A) et une couche d'enregistrement photopolymérisable formant le relief B),

(2) lavage (développement) à l'aide d'un solvant révélateur des régions non exposées et par conséquent non photopolymérisées de la couche d'enregistrement formant le relief, exposée à la lumière avec formation d'une image, et

(3) nouvelle exposition (traitement complémentaire) de la couche de relief photopolymérisée ainsi obtenue, à la lumière d'une longueur d'onde $\lambda$ inférieure ou égale à 300 nm,

caractérisé en ce que l'on utilise à cet effet un élément d'enregistrement photosensible selon une des revendications 1 à 5.